# EUROPÄISCHE PATENTSCHRIFT

(11) **EP 3 503 694 B1**
(45) Veröffentlichungstag und Bekanntmachung des Hinweises auf die Patenterteilung: **03.07.2024**
(21) Anmeldenummer: 17209714.9
(22) Anmeldetag: 21.12.2017
(51) Int. Cl.: H05K 1/02, H05K 1/05, H05K 3/40, H05K 3/00

(54) **VERFAHREN ZUM HERSTELLEN EINER WÄRMELEITENDEN VERBINDUNG ZWISCHEN EINEM LEISTUNGSBAUTEIL UND EINER METALLISCHEN SCHICHT EINES SCHALTUNGSTRÄGERS**
METHOD FOR PRODUCING A HEAT-CONDUCTING CONNECTION BETWEEN A POWER COMPONENT AND A METALLIC LAYER OF A CIRCUIT CARRIER
PROCÉDÉ D'ÉTABLISSEMENT D'UNE LIAISON THERMOCONDUCTRICE ENTRE UN COMPOSANT DE PUISSANCE ET UNE COUCHE MÉTALLIQUE D'UN SUPPORT DE CIRCUIT

(43) Veröffentlichungstag der Anmeldung: 26.06.2019
(73) Patentinhaber: ZKW Group GmbH, 3250 Wieselburg (AT)
(72) Erfinder: Haiden, Christoph, 2630 Ternitz (AT); Wurm, Peter, 7000 Eisenstadt (AT)
(74) Vertreter: Patentanwaltskanzlei Matschnig & Forsthuber OG

(56) Entgegenhaltungen:
- DE-A1-102010 011 604
- US-A1- 2009 201 699
- US-A1- 2012 025 257

## Beschreibung

Die Erfindung bezieht sich auf ein Verfahren zum Herstellen zumindest einer wärmeleitenden Verbindung zwischen einem Leistungsbauteil und einer metallischen Schicht eines Schaltungsträgers, wobei der Schaltungsträger eine metallische Basisschicht und auf dieser an zumindest einer ihrer Seiten eine Isolierschicht aufweist, wobei auf der Isolierschicht eine Leiterbahnschicht mit Leiterbahnabschnitten angeordnet ist und darüber abschnittsweise eine Schicht aus Lötstopplack aufgebracht ist, und der Leistungsbauteil an seiner Unterseite außer elektrischen Kontakten zumindest einen potentialfreien Wärmeleitkontakt zur Ableitung von Verlustwärme besitzt.

Ebenso bezieht sich die Erfindung auf einen Schaltungsträger mit zumindest einer wärmeleitenden Verbindung zwischen einem Leistungsbauteil und einer metallischen Schicht des Schaltungsträgers, welcher eine metallische Basisschicht und auf dieser an zumindest einer ihrer Seiten eine Isolierschicht aufweist, wobei auf der Isolierschicht eine Leiterbahnschicht mit Leiterbahnabschnitten angeordnet ist und darüber abschnittsweise eine Schicht aus Lötstopplack aufgebracht ist, und der Leistungsbauteil an seiner Unterseite außer elektrischen Kontakten zumindest einen potentialfreien Wärmeleitkontakt zur Ableitung von Verlustwärme besitzt.

Als Schaltungsträger dieser Art sind beispielsweise sogenannte IMS-Leiterplatten (IMS = Insulated Metallic Substrate) bekannt, die bei einseitigen Ausführungen aus einem Substrat, meist ein Aluminium- oder Kupferblech, einer durchgehenden Isolationsschicht und darauf einer Kupferschicht bestehen, in der bei der Leiterplattenherstellung das Leiterbahnbild eingearbeitet wird, üblicherweise nasschemisch geätzt. Das Dielektrikum stellt bei IMS-Leiterplatten mit einem Aluminiumsubstrat eine durchgehende Barriere zwischen Substrat und Leiterbahnbild dar, die im Rahmen der PCB-Fertigung nicht strukturiert oder gezielt durchbrochen werden kann. Die Dicke der Substrat-Aluminium- oder Kupferschicht beträgt beispielsweise 1 mm bis 2 mm, jene der dielektrischen Isolierschicht beispielsweise 100 µm (Mikrometer) und jene der Leiterbahnenschicht aus Kupfer 20 bis 105 µm (Mikrometer). Die genannten Zahlenwerte sollen lediglich eine Vorstellung über die Schichtdicken geben und können je nach Anwendungsfall auch erheblich andere Werte aufweisen.

Ein der Erfindung zugrunde liegendes Problem liegt darin, dass bekannte Verfahren der gegenständlichen Art zur Herstellung einer wärmeleitenden Verbindung aufwändig sind und den Einsatz besonderer Bearbeitungsmittel verlangen, wodurch das Endprodukt teuer wird. Dokument DE 10 2010 011 604 A1 offenbart eine flexible Leiterplatte, auf welche mindestens eine Strahlungsquelle aufgebracht ist, bestehend aus einem Foliensystem. Dokumente US 2012/0025357 A1 sowie US 2009/0201699 A1 zeigen Leuchtvorrichtungen inklusive daran angeordneter Kühlvorrichtungen.

Eine Aufgabe der Erfindung liegt daher darin, ein kostengünstiges und einfacheres Verfahren zur Herstellung einer wärmeleitenden Verbindung zu schaffen, das ein vergleichsweise billiges Endprodukt mit guten Eigenschaften bezüglich der Wärmeableitung von Leistungsbauteilen schafft.

Diese Aufgabe wird mit einem Verfahren gemäß Anspruch 1 gelöst.

Die Erfindung bietet unter anderem den Vorteil, dass sie auf herkömmlichen Fertigungsstraßen ausgeführt werden kann. So sind zur Herstellung der erforderlichen Abtragungen und Ausnehmungen keine Sonderwerkzeuge erforderlich. Für die Laserbearbeitung kann beispielsweise ein ohnedies vorhandener Beschriftungslaser verwendet werden.

Erfindungsgemäß ist vorgesehen, dass der potentialfreie Wärmeleitkontakt des Leistungsbauteils mit einem Anschlusspad der oberen Leiterbahnschicht verlötet wird und über den Graben ragender Leitkleber auf einen Abschnitt des Anschlusspads aufgebracht wird, sodass das Anschlusspad über den Leitkleber mit der Basisschicht in thermischer Verbindung steht.

Es kann zweckmäßig sein, wenn das Entfernen der oberhalb der Basisschicht liegenden Isolierschicht mit Hilfe der Laserstrahlung eines Lasers erfolgt.

Erfindungsgemäß wird der Graben so mit Leitkleber gefüllt, dass dieser über das Ende des Grabens ragt.

Erfindungsgemäß ist vorgesehen, dass als Leitkleber ein Silberleitkleber verwendet wird.

Andererseits kann es zweckmäßig sein, das Füllen des Grabens mit Leitkleber nach dem Aufbringen der Lotpaste erfolgt.

Mit Vorteil kann vorgesehen sein, wenn die metallische Basisschicht ein Aluminiumsubstrat ist.

Bei einer zweckmäßigen Variante kann vorgesehen sein, dass die metallische Basisschicht eine Kupferlage ist.

Die gestellten Aufgaben werden auch mit einem Schaltungsträger gemäß Anspruch 1 erreicht.

Die Erfindung samt weiteren Vorteilen ist im Folgenden an Hand beispielsweiser Ausführungsformen näher erläutert, die in der Zeichnung veranschaulicht sind. In dieser zeigen
Fig. 1 in schematischer Draufsicht und jeweils zugehörigen Schnitten in vergrößerter Ansicht vier Schritte bei einer ersten Ausführungsform der Erfindung,
Fig. 2 in schematischer Draufsicht und jeweils zugehörigen Schnitten in vergrößerter Ansicht vier Schritte bei einer zweiten Ausführungsform der Erfindung,
Fig. 3 in schematischer Draufsicht und jeweils zugehörigen Schnitten in vergrößerter Ansicht vier Schritte bei einer dritten Ausführungsform der Erfindung und
Fig. 4 in schematischer Draufsicht und jeweils zugehörigen Schnitten in vergrößerter Ansicht vier Schritte bei einer vierten Ausführungsform der Erfindung,

In den folgenden Figuren werden für gleiche oder vergleichbare Elemente zum Zwecke der einfacheren Erläuterung und Darstellung gleiche Bezugszeichen verwendet.

Die in den Ansprüchen verwendeten Bezugszeichen sollen weiters lediglich die Lesbarkeit der Ansprüche und das Verständnis der Erfindung erleichtern und haben keinesfalls einen den Schutzumfang der Erfindung beeinträchtigenden Charakter.

Begriffe hinsichtlich des Ortes oder einer Orientierung, wie beispielsweise "oben", "unten", "vorne", *"*darunter*"*, *"*darüber*"* etc. werden in der Beschreibung lediglich zur Vereinfachung gewählt und beziehen sich möglicherweise auf die Darstellung in der Zeichnung, nicht jedoch notwendigerweise auf eine Gebrauchs- oder Einbaulage. Insbesondere beziehen sich die Begriffe Oberseite und Unterseite in dieser Beschreibung und den Ansprüchen lediglich auf die Darstellung in der Zeichnung und sind nicht als einschränkend zu verstehen. Selbstverständlich kann der Schaltungsträger auch in allen anderen möglichen Orientierungen, wie umgekehrt, stehend oder schräg verwendet bzw. in Geräte eingebaut werden.

Die Bezeichnung "elektronischer Bauteil" ist dahingehend zu verstehen, dass er sämtliche Bauteile umfassen soll, die mit Leiterbahnen in elektrischer Verbindung stehen können, wie Chips, die integrierte Schaltungen beinhalten, digitale oder analoge Prozessoren aber auch einfachere Bauelemente, wie LEDs, Widerstände und dgl. mehr. *"*Leistungsbauteile*"* sind solche Bauteile, die sich in Hinblick auf die entstehende und abzuführende Verlustwärme von anderen Bauteilen unterscheiden, wobei die Wärmeabfuhr durch besondere Maßnahmen erfolgen muss, um eine Beschädigung der Bauteile als solche oder deren Umgebung zu verhindern.

Beispielsweise sind LED-Chips, wie sie in der KFZ-Beleuchtungstechnik verwendet werden, in diesem Sinn als Leistungsbauteile zu bezeichnen. Unter einem potentialfreien Wärmeleitkontakt eines Leistungsbauteils ist ein Anschluss zu verstehen, der ausschließlich der Ableitung von Verlustwärme dient und nicht elektrisch mit Schaltelementen, ganz allgemein der Beschaltung des Leistungsbauteils verbunden ist.

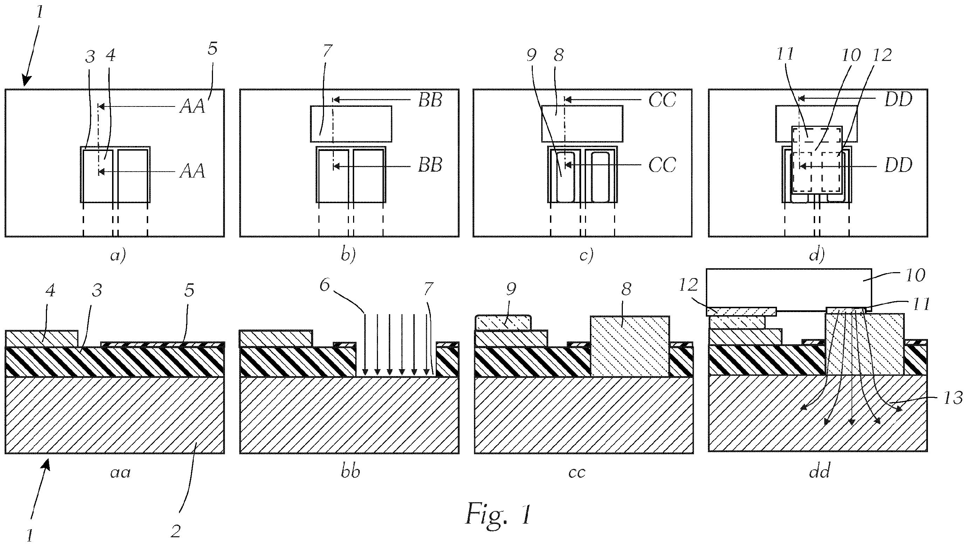

Nun wird auf **Fig. 1** Bezug genommen, welche als Schaltungsträger 1 eine eingangs beschriebene IMS-Leiterplatte (IMS = Insulated Metallic Substrate) zeigt. In Fig. 1a mit ihrer Draufsicht und dem zugehörigen Schnitt aa erkennt man die metallische Basisschicht **2,** die vorzugsweise aus Aluminium besteht und auf welcher eine Isolierschicht **3,** beispielsweise aus Epoxidharz mit Füllstoffen, aufgebracht ist. Auf der Isolierschicht 3 ist eine strukturierte Leiterbahnschicht **4** mit Leiterbahnabschnitten angeordnet. Darüber, d.h. auf der Leiterbahnschicht 4 bzw. auf der Isolierschicht 3 ist zumindest abschnittsweise eine Schicht aus Lötstopplack **5** aufgebracht.

In der in Zusammenhang mit Fig. 1 beschriebenen ersten Variante der Erfindung ist für einen potentialfreien Wärmeleitkontakt eines Leistungsbauteils kein Kupfer im Leiterbahnbild der Oberseite vorgesehen. Es wird daher an jener Position, an welcher der Wärmeleitkontakt ("thermal Pad") des Bauteils auf dem Schaltungsträger 1 zu liegen kommen soll, der Lötstopplack und die Isolierschicht 3 ("Dielektrikum") lokal z.B. mittels Laserstrahlung entfernt und der entstehende Graben mit Leitkleber gefüllt, typischerweise im Anschluss an den Pastendruck auf die anderen dafür vorgesehenen Bereiche. Danach wird das Bauteil bestückt und in einem Reflow-Ofen verlötet, wodurch auch der Kleber aushärtet und direkt als thermische Anbindung von Bauteil zu Metallsubstrat dient. Dies wird im Einzelnen nun näher erläutert.

Fig. 1b mit ihrer Draufsicht und dem zugehörigen Schnitt bb zeigt einen ersten Schritt des erfindungsgemäßen Verfahrens, bei welchem in einem von der Leiterbahnschicht 4 freien Verbindungsbereich des Schaltungsträgers 1 die oberhalb der Basisschicht 2 liegende Isolierschicht 3 entfernt wird. Falls der genannte Bereich auch mit Lötstopplack 5 bedeckt ist, wie im vorliegenden Beispiel, wird hier auch der Lötstopplack entfernt. Das Entfernen der oberhalb der Basisschicht 2 liegenden Isolierschicht 3 erfolgt vorzugsweise mit Hilfe der durch Pfeile 6 angedeuteten Laserstrahlung eines nicht gezeigten Lasers, doch kann diese Bearbeitung prinzipiell durch jedes geeignete andere Abtragungsverfahren erfolgen, wie auch mechanisch, z.B. durch Fräsen.

Durch das lokale Entfernen der Isolierschicht 3 entsteht ein Graben 7, der bis zu der Basisschicht 2 reicht, und dieser Graben 7 wird daraufhin, wie in Fig. 1c mit ihrer Draufsicht und dem zugehörigen Schnitt cc veranschaulicht, mit einem Leitkleber 8 gefüllt. Der Boden des Grabens 7 wird im Zuge des Entfernens der Isolierschicht 3 aufgeraut, damit sich ein guter Kontakt zu einem Leitkleber ergibt. Im Bereich der elektrischen Kontakte eines Leistungsbauteils, mit dem der Schaltungsträger bestückt werden soll, wird Lotpaste 9 auf die erforderlichen Stellen, wie Lötpads, Leiterbahnschicht 4 aufgebracht. Als Leitkleber wird bevorzugt ein Silberleitkleber verwendet, der zu allen gelaserten und dadurch aufgerauten Al- und Cu-Flächen sowie zu den Bauteilen eine ausreichende Adhäsion aufweist. Dies gilt auch für ein Leiterplattendesign mit ENIG-Finish (Electroless Nickel Immersion Gold).

In einem nächsten Schritt, wie in Fig. 1d mit ihrer Draufsicht und dem zugehörigen Schnitt dd veranschaulicht, erfolgt die Bestückung des Schaltungsträgers 1 mit einem Leistungsbauteil 10, der in der korrekten Position aufgesetzt wird, wonach durch Erwärmen sowohl der Lötprozess als auch das Aushärten des Leitklebers 8 erfolgt, sodass eine wärmeleitende Verbindung von einem potentialfreien Wärmeleitkontakt **11** des Leistungsbauteils 10 zu der unteren metallischen Basisschicht 2 über den Leitkleber 8 geschaffen wird. Im Zuge des Lötprozesses werden elektrische Kontakte **12** des Leistungsbauteil 10 mit der Leiterbahnschicht 4 verlötet. Pfeile 13 sollen den Wärmefluss aus dem Bauteil 10 über den Wärmeleitkontakt 11 und die Lotpaste 8 in die Basisschicht 2 andeuten.

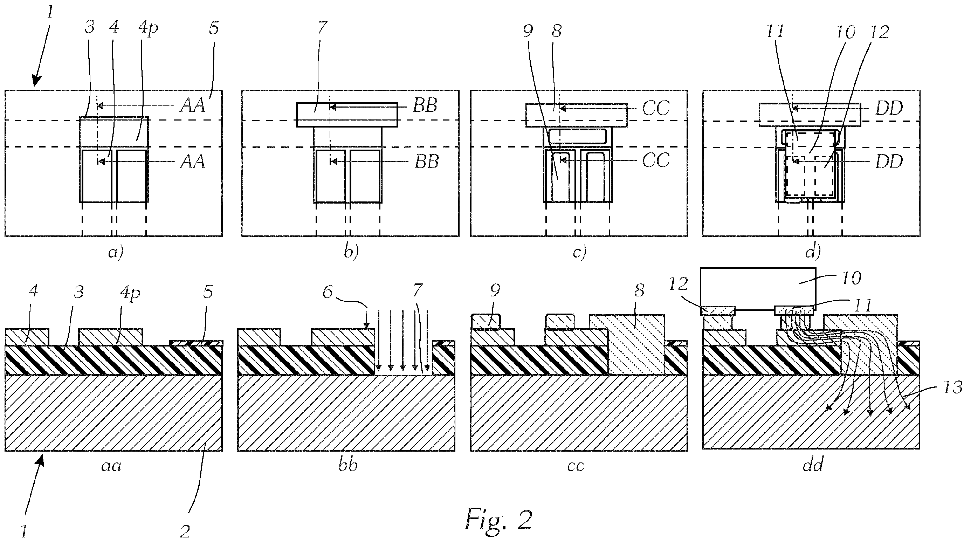

Im Folgenden wird auf **Fig. 2** Bezug genommen, welche eine Variante der Erfindung zeigt, bei welcher die Wärme aus dem Leistungsbauteil 10 gleichfalls über einen potentialfreien Wärmeleitkontakt 11 und Leitkleber 8 in die Basisschicht 2 abgeführt wird, jedoch über einen kurzen Abschnitt eines Anschlusspads **4p.**

Fig. 2a mit ihrer Draufsicht und dem zugehörigen Schnitt aa entspricht im Wesentlichen der Darstellung der Fig. 1a, doch ist hier in der strukturierten Leiterbahnschicht 4 mit Leiterbahnabschnitten ein Anschlusspad 4p für einen potentialfreien Wärmeleitkontakt 11 eines Leistungsbauteil 10 vorgesehen. Auch hier erkennt man abschnittsweise aufgebrachten Lötstopplack 5.

Wiederum wird gemäß Fig. 2b mit ihrer Draufsicht und dem zugehörigen Schnitt bb in einem ersten Schritt des erfindungsgemäßen Verfahrens in einem von der Leiterbahnschicht 4 freien Verbindungsbereich des Schaltungsträgers 1 die oberhalb der Basisschicht 2 liegende Isolierschicht 3 entfernt und ein Graben 7 geschaffen, der bis zu der Basisschicht 2 reicht. Gleichzeitig wird ein an den Graben 7 angrenzender Bereich des Anschlusspads 4p mit Hilfe des Lasers aufgeraut um später eine gute Verbindung mit dem aufzubringenden Leitkleber zu ermöglichen. Die genannte Bearbeitung könnte auch bei diesem Beispiel mechanisch erfolgen.

Wie in Fig. 2c mit ihrer Draufsicht und dem zugehörigen Schnitt cc veranschaulicht, wird nun in einem nächsten Schritt der Graben 7 mit Leitkleber 8 gefüllt, wobei über den Graben ragender Leitkleber auf einen Abschnitt des Anschlusspads 4p aufgebracht wird. Im Bereich der elektrischen Kontakte des Leistungsbauteils sowie seines potentialfreien Wärmeleitkontakts wird Lotpaste 9 auf die erforderlichen Stellen, wie Lötpads und das Anschlusspad 4p der Leiterbahnschicht 4 aufgebracht.

In einem nächsten Schritt, wie in Fig. 2d mit ihrer Draufsicht und dem zugehörigen Schnitt dd veranschaulicht, erfolgt die Bestückung des Schaltungsträgers 1 mit dem Leistungsbauteil 10, so wie bereits weiter oben beschrieben. Nach Erwärmen zum Ausführen des Lötprozess und zum Aushärten des Leitklebers 8, sind sowohl die elektrischen Verbindungen als auch die metallische Verbindung des potentialfreien Wärmeleitkontakts 11 mit dem Anschlusspad 4p geschaffen als auch eine thermische Verbindung von dem Wärmeleitkontakt 11 über das Anschlusspad 4p und den Leitkleber 8 bis zu der Basisschicht 2 hergestellt. Auch hier deuten Pfeile den Wärmefluss aus dem Bauteil 10 in die Basisschicht 2 an.

Es sollte klar sein, dass die Entfernung zwischen dem potentialfreien Wärmeleitkontakt 11 bzw. dem Anschlusspad 4p und dem Graben 7 mit dem Leitkleber 8 so gering wie möglich sein sollte, damit die Verlustwärme auf kürzestem Weg abgeleitet werden kann. Typischerweise und bevorzugt liegen die für den Wärmetransport wesentlichen Abmessungen in folgenden Bereichen:
Abmessung des potentialfreien Wärmeleitkontaktes 11: ab ca. 0,5 mm.
Abmessungen des Anschlusspads 4p: ab 0,3 mm.
Abmessungen des Grabens 7: ab 0,1 mm.
Erfindungsgemäße Abmessungen des Leitkleberpfropfens 8: von 0,1 mm bis 0,5 mm.

Wenngleich bei dieser Ausführung ein etwas längerer Pfad für die Wärmeleitung vorliegt als bei dem vorgenannten Beispiel der Fig. 1 ergibt sich andererseits der Vorteil, dass das Leistungsbauteil mechanisch ausschließlich durch Löten mit dem Schaltungsträger verbunden wird.

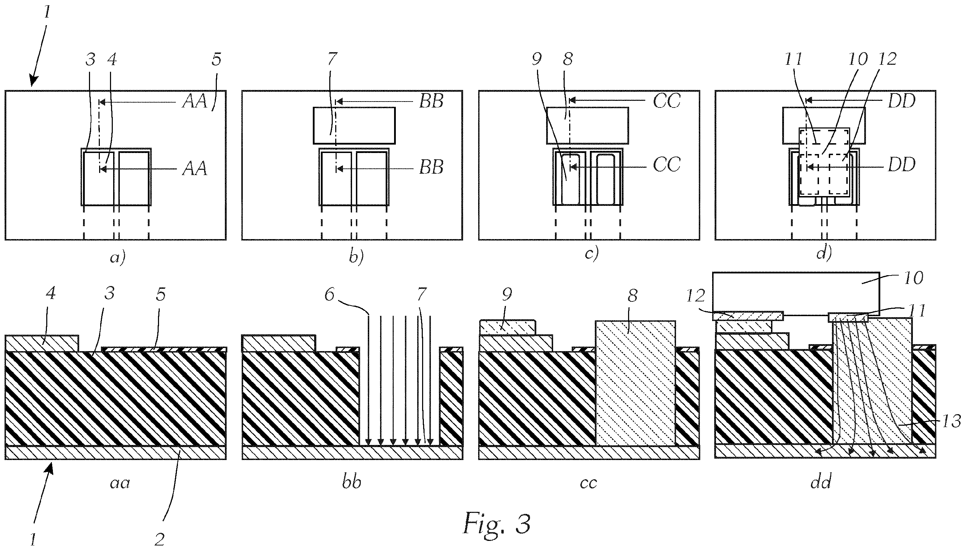

Es wird nun auf **Fig. 3** Bezug genommen, welche eine Variante der Erfindung zeigt, bei welcher der Schaltungsträger als FR4-Platine ausgeführt ist, die eine obere und untere Kupferlage mit einer dazwischen liegenden FR4-Schicht aufweist.

In Fig. 3a mit ihrer Draufsicht und dem zugehörigen Schnitt aa erkennt man die metallische Basisschicht 2, die bei diesem Beispiel eine Kupferschicht ist, deren Dicke bevorzugt im Bereich von 15 µm bis 105 µm (Mikrometer), seltener bis 210 µm (Mikrometer) liegt. Auf der unteren Kupferschicht, d.h. der Basisschicht 2, liegt als Isolierschicht 3, eine FR4-Schicht aus Epoxidharz mit Füllstoffen. Auf der Isolierschicht 3 ist wie bei den vorangehenden Beispielen eine strukturierte Leiterbahnschicht 4 mit Leiterbahnabschnitten angeordnet. Auf der Leiterbahnschicht 4 bzw. auf der Isolierschicht 3 ist zumindest abschnittsweise eine Schicht aus Lötstopplack 5 aufgebracht.

Die weitere Herstellung und Bestückung des Schaltungsträgers 1 erfolgt völlig analog zu der Ausgestaltung des zusammen mit Fig. 1 beschriebenen ersten Beispiels, sodass eine Wiederholung der einzelnen Verfahrensschritte, gezeigt in den Draufsichten a bis d und den Schnitten aa bis dd der Fig.3 nicht erforderlich ist.

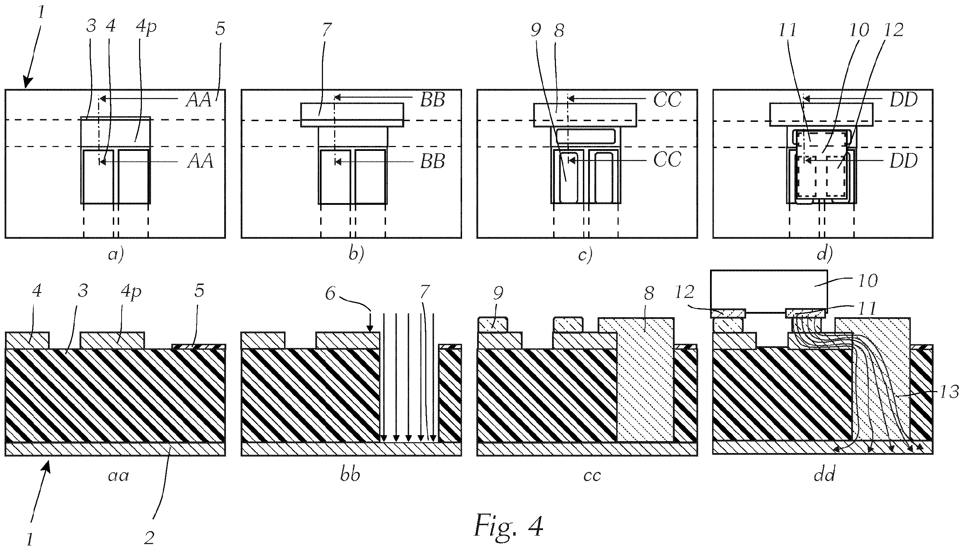

Ein viertes Beispiel der Erfindung ist in **Fig. 4** dargestellt. Diese Figur und der darin dargestellte Schaltungsträger 1 sowie das entsprechende Verfahren zu dessen Herstellung entsprechen genau der Fig. 2 und der zugehörigen Beschreibung mit Ausnahme des Umstands, dass an Stelle einer IMS-Leiterplatte der Fig. 2 eine FR4-Leiterplatte wie bei dem dritten Beispiel nach Fig. 3 Ausgangspunkt des Schaltungsträgers 1 ist. Die Wiederholung einer ausführlichen Beschreibung erübrigt sich, da alle notwendigen Details in Zusammenhang mit Fig. 2 bereits beschrieben wurden und in Fig. 4 auch die gleichen Bezugszeichen wie in Fig. 2 verwendet werden.

Es ist anzumerken, dass die in der Zeichnung gezeigten Ausführungsbeispiele alleine schon zwecks einfacherer Darstellung einen Aufbau zeigen, der lediglich eine untere Basisschicht, eine Isolierschicht und eine Leiterbahnschicht aufweist, wozu noch abschnittsweise eine Schicht aus Lötstopplack kommt. Es sollte aber klar sein, dass im Rahmen der Erfindung auch andere Schichtaufbauten in Frage kommen, beispielsweise eine IMS-Platte mit einer mittigen Aluminium-Basisschicht, die oben und unten eine Isolierschicht und darüber eine Leiterstruktur aufweisen kann. Bei einer solchen Ausführung könnten Bauteile sowohl an der Oberseite als auch an der Unterseite des Schaltungsträgers sitzen und eine Wärmeableitung zur Mitte hin erfolgen. Prinzipiell ist auch ein mehrschichtiger Aufbau mit zwei oder mehr Leiterstrukturen und dazwischen liegenden Isolierschichten möglich, wobei die Ableitung der Wärme im Sinne der vorliegenden Erfindung von Bauteilen erfolgt, die auf der obersten Leiterstruktur sitzen.

### Liste der Bezugszeichen

- 1: Schaltungsträger
- 2: Basisschicht
- 3: Isolierschicht
- 4: Leiterbahnschicht
- 4p: Anschlusspad
- 5: Lötstopplack
- 6: Pfeile
- 7: Graben
- 8: Leitkleber
- 9: Lotpaste
- 10: Leistungsbauteil
- 11: Wärmeleitkontakt
- 12: elektrische Kontakte
- 13: Pfeile

## Patentansprüche

1. Verfahren zum Herstellen zumindest einer wärmeleitenden Verbindung zwischen einem Leistungsbauteil (10) und einer metallischen Schicht eines Schaltungsträgers (1), wobei der Schaltungsträger eine metallische Basisschicht (2) und auf dieser an zumindest einer ihrer Seiten eine Isolierschicht (3) aufweist, auf der Isolierschicht eine Leiterbahnschicht (4) mit Leiterbahnabschnitten angeordnet ist und darüber abschnittsweise eine Schicht aus Lötstopplack (5) aufgebracht ist, und der Leistungsbauteil an seiner Unterseite außer elektrischen Kontakten (12) zumindest einen potentialfreien Wärmeleitkontakt (11) zur Ableitung von Verlustwärme besitzt, wobei in einem von der Leiterbahnschicht (4) freien Verbindungsbereich des Schaltungsträgers (1) die oberhalb der Basisschicht (2) liegende Isolierschicht (3) entfernt wird, der dadurch entstandene Graben (7) mit einem Leitkleber (8) gefüllt wird, und im Bereich der elektrischen Kontakte (12) des Leistungsbauteils (10) Lotpaste (9) auf die Leiterbahnschicht (4) aufgebracht wird, daraufhin der Leistungsbauteil (10) aufgebracht und durch Erwärmen sowohl der Lötprozess als auch das Aushärten des Leitklebers (8) durchgeführt werden, sodass eine wärmeleitende Verbindung von dem potentialfreien Wärmeleitkontakt (11) zu der unteren metallischen Basisschicht (2) über den Leitkleber (8) geschaffen wird und die elektrischen Kontakte (12) mit der Leiterbahnschicht (4) verlötet werden, **dadurch gekennzeichnet, dass** als Leitkleber (8) ein Silberleitkleber verwendet wird, wobei der potentialfreie Wärmeleitkontakt (11) des Leistungsbauteils (10) mit einem Anschlusspad (4p) der oberen Leiterbahnschicht (4) verlötet wird und über den Graben (7) ragender Leitkleber (8) auf einen Abschnitt des Anschlusspads (4p) aufgebracht wird, sodass das Anschlusspad (4p) über den Leitkleber (8) mit der Basisschicht (2) in thermischer Verbindung steht, wobei der Graben (7) so mit Leitkleber (8) gefüllt wird, dass dieser über das Ende des Grabens (7) ragt, wobei die Abmessungen eines durch den Leitkleber (8) ausgebildeten Leitkleberpfropfens zwischen 0,1 mm bis 0,5 mm betragen, wobei das Leistungsbauteil (10) mechanisch ausschließlich durch Löten mit dem Schaltungsträger (1) verbunden wird.

2. Verfahren nach Anspruch 1, **dadurch gekennzeichnet, dass** das Entfernen der oberhalb der Basisschicht (2) liegenden Isolierschicht (3) mit Hilfe der Laserstrahlung eines Lasers erfolgt.

3. Verfahren nach Anspruch 1 oder 2, **dadurch gekennzeichnet, dass** das Füllen des Grabens (7) mit Leitkleber (8) nach dem Aufbringen der Lotpaste (9) erfolgt.

4. Verfahren nach einem der Ansprüche 1 bis 3, **dadurch gekennzeichnet, dass** die metallische Basisschicht (2) ein Aluminiumsubstrat ist.

5. Verfahren nach einem der Ansprüche 1 bis 3, **dadurch gekennzeichnet, dass** die metallische Basisschicht (2) eine Kupferlage ist.

6. Schaltungsträger (1) mit zumindest einer wärmeleitenden Verbindung zwischen einem Leistungsbauteil (10) und einer metallischen Schicht des Schaltungsträgers (1), welcher eine metallische Basisschicht (2) und auf dieser an zumindest einer ihrer Seiten eine Isolierschicht (3) aufweist, wobei auf der Isolierschicht eine Leiterbahnschicht (4) mit Leiterbahnabschnitten angeordnet ist und darüber abschnittsweise eine Schicht aus Lötstopplack (5) aufgebracht ist, und der Leistungsbauteil an seiner Unterseite außer elektrischen Kontakten (12) zumindest einen potentialfreien Wärmeleitkontakt (11) zur Ableitung von Verlustwärme besitzt, wobei in einem von der Leiterbahnschicht (4) freien Verbindungsbereich ein Graben (7) mit einem Leitkleber (8) gefüllt ist, sodass eine wärmeleitende Verbindung von dem potentialfreien Wärmeleitkontakt (11) zu der unteren metallischen Basisschicht (2) über den Leitkleber geschaffen ist, **dadurch gekennzeichnet, dass** der Leitkleber (8) ein Silberleitkleber ist, wobei der potentialfreie Wärmeleitkontakt (11) des Leistungsbauteils (10) mit einem Anschlusspad (4p) der oberen Leiterbahnschicht (4) verlötet ist und über den Graben (7) ragender Leitkleber (8) auf einen Abschnitt des Anschlusspads aufgebracht ist, sodass das Anschlusspad über den Leitkleber mit der Basisschicht (2) in thermischer Verbindung steht, wobei der Leitkleber (8) über das Ende des Grabens (7) ragt, wobei die Abmessungen eines durch den Leitkleber (8) ausgebildeten Leitkleberpfropfens zwischen 0,1 mm bis 0,5 mm betragen, wobei das Leistungsbauteil (10) mechanisch ausschließlich durch Löten mit dem Schaltungsträger (1) verbunden wird.

7. Schaltungsträger (1) nach Anspruch 6, **dadurch gekennzeichnet, dass** die metallische Basisschicht (2) ein Aluminiumsubstrat ist.

8. Schaltungsträger (1) nach Anspruch 6 oder 7, **dadurch gekennzeichnet, dass** die metallische Basisschicht (2) eine Kupferlage ist.

## Claims

1. Method for producing at least one thermally conductive connection between a power component (10) and a metallic layer of a circuit carrier (1), the circuit carrier having a metallic base layer (2) and an insulating layer (3) on at least one of its sides, a conductor track layer (4) with conductor track sections being arranged on the insulating layer and a layer of solder resist (5) being applied in sections thereover, and the power component has on its underside, in addition to electrical contacts (12), at least one potential-free heat conducting contact (11) for dissipating heat loss, the insulating layer (3) lying above the base layer (2) being removed in a connection region of the circuit carrier (1) which is free from the conductor track layer (4), the resulting trench (7) is filled with a conductive adhesive (8), and solder paste (9) is applied to the conductor track layer (4) in the region of the electrical contacts (12) of the power component (10), the power component (10) is then applied and both the soldering process and the curing of the conductive adhesive (8) are carried out by heating, so that a thermally conductive connection is created from the potential-free thermally conductive contact (11) to the lower metallic base layer (2) via the conductive adhesive (8) and the electrical contacts (12) are soldered to the conductor track layer (4), **characterized in that in that** a silver conductive adhesive is used as the conductive adhesive (8), the potential-free heat conducting contact (11) of the power component (10) being soldered to a connection pad (4p) of the upper conductor track layer (4) and conductive adhesive (8) projecting over the trench (7) being applied to a section of the connection pad (4p), so that the connection pad (4p) is in thermal connection with the base layer (2) via the conductive adhesive (8), the trench (7) being filled with conductive adhesive (8) in such a way that the latter projects beyond the end of the trench (7), the dimensions of a plug of conductive adhesive formed by the conductive adhesive (8) being between 0.1 mm and 0.5 mm, the power component (10) being mechanically connected to the circuit carrier (1) exclusively by soldering.

2. Method according to claim 1, **characterized in that** the removal of the insulating layer (3) lying above the base layer (2) is carried out with the aid of the laser radiation of a laser.

3. Method according to claim 1 or 2, **characterized in that** the filling of the trench (7) with conductive adhesive (8) takes place after the application of the solder paste (9).

4. Method according to one of claims 1 to 3, **characterized in that** the metallic base layer (2) is an aluminum substrate.

5. Method according to one of claims 1 to 3, **characterized in that** the metallic base layer (2) is a copper layer.

6. Circuit carrier (1) with at least one thermally conductive connection between a power component (10) and a metallic layer of the circuit carrier (1), which has a metallic base layer (2) and on this an insulating layer (3) on at least one of its sides, a conductor track layer (4) with conductor track sections being arranged on the insulating layer and a layer of solder resist (5) being applied over this in sections, and the power component has on its underside, in addition to electrical contacts (12), at least one potential-free heat-conducting contact (11) for dissipating heat loss, a trench (7) being filled with a conductive adhesive (8) in a connection region free of the conductor track layer (4), so that a thermally conductive connection is created from the potential-free thermally conductive contact (11) to the lower metallic base layer (2) via the conductive adhesive, **characterized in that** the conductive adhesive (8) is a silver conductive adhesive, the potential-free heat conducting contact (11) of the power component (10) being soldered to a connection pad (4p) of the upper conductor track layer (4) and conductive adhesive (8) projecting over the trench (7) being applied to a section of the connection pad, so that the connection pad is in thermal connection with the base layer (2) via the conductive adhesive, the conductive adhesive (8) projecting beyond the end of the trench (7), the dimensions of a plug of conductive adhesive formed by the conductive adhesive (8) being between 0.1 mm and 0.5 mm, the power component (10) being mechanically connected to the circuit carrier (1) exclusively by soldering.

7. Circuit carrier (1) according to claim 6, **characterized in that** the metallic base layer (2) is an aluminum substrate.

8. Circuit carrier (1) according to claim 6 or 7, **characterized in that** the metallic base layer (2) is a copper layer.

## Revendications

1. Procédé de fabrication d'au moins une liaison thermoconductrice entre un composant de puissance (10) et une couche métallique d'un support de circuit (1), le support de circuit présentant une couche de base métallique (2) et sur celle-ci, sur au moins l'un de ses côtés, une couche isolante (3), une couche de pistes conductrices (4) avec des sections de pistes conductrices étant disposée sur la couche isolante et une couche de vernis épargne de brasage (5) étant appliquée par-dessus par sections, et le composant de puissance possède sur sa face inférieure, outre des contacts électriques (12), au moins un contact thermoconducteur sans potentiel (11) pour la dissipation de la chaleur perdue, la couche isolante (3) située au-dessus de la couche de base métallique (2) étant enlevée dans une zone de liaison du support de circuit (1) exempte de la couche de pistes conductrices (4), la tranchée (7) ainsi créée est remplie d'une colle conductrice (8), et de la pâte à braser (9) est appliquée sur la couche de pistes conductrices (4) dans la zone des contacts électriques (12) du composant de puissance (10), le composant de puissance (10) est ensuite appliqué et, par chauffage, aussi bien le processus de brasage que le durcissement de la colle conductrice (8) sont effectués, de sorte qu'une connexion thermoconductrice est créée entre le contact thermoconducteur sans potentiel (11) et la couche de base métallique inférieure (2) par l'intermédiaire de la colle conductrice (8), et les contacts électriques (12) sont soudés à la couche de piste conductrice (4), **caractérisé en ce que en ce que** l'on utilise comme colle conductrice (8) une colle conductrice à l'argent, le contact thermoconducteur sans potentiel (11) du composant de puissance (10) étant soudé à un plot de raccordement (4p) de la couche supérieure de pistes conductrices (4) et de la colle conductrice (8) dépassant de la tranchée (7) étant appliquée sur une section du plot de raccordement (4p), de sorte que le plot de connexion (4p) est en liaison thermique avec la couche de base (2) par l'intermédiaire de la colle conductrice (8), la tranchée (7) étant remplie de colle conductrice (8) de telle sorte que celle-ci dépasse de l'extrémité de la tranchée (7), les dimensions d'un bouchon de colle conductrice formé par la colle conductrice (8) étant comprises entre 0,1 mm et 0,5 mm, le composant de puissance (10) étant relié mécaniquement au support de circuit (1) exclusivement par brasage.

2. Procédé selon la revendication 1, **caractérisé en ce que** l'élimination de la couche isolante (3) située au-dessus de la couche de base (2) est effectuée à l'aide du rayonnement laser d'un laser.

3. Procédé selon la revendication 1 ou 2, **caractérisé en ce que** le remplissage de la tranchée (7) avec de la colle conductrice (8) est effectué après l'application de la pâte à braser (9).

4. Procédé selon l'une des revendications 1 à 3, **caractérisé en ce que** la couche métallique de base (2) est un substrat en aluminium.

5. Procédé selon l'une des revendications 1 à 3, **caractérisé en ce que** la couche de base métallique (2) est une couche de cuivre.

6. Support de circuit (1) avec au moins une liaison thermoconductrice entre un composant de puissance (10) et une couche métallique du support de circuit (1), qui présente une couche de base métallique (2) et sur celle-ci, sur au moins l'un de ses côtés, une couche isolante (3), une couche de piste conductrice (4) avec des sections de piste conductrice étant disposée sur la couche isolante et une couche de vernis épargne de brasage (5) étant appliquée par-dessus par sections, et le composant de puissance possède sur sa face inférieure, outre des contacts électriques (12), au moins un contact thermoconducteur sans potentiel (11) pour la dissipation de la chaleur perdue, une tranchée (7) étant remplie d'une colle conductrice (8) dans une zone de liaison libre de la couche de pistes conductrices (4), de sorte qu'une liaison thermoconductrice est créée entre le contact thermoconducteur sans potentiel (11) et la couche de base métallique inférieure (2) par l'intermédiaire de la colle conductrice, **caractérisé en ce que** la colle conductrice (8) est un adhésif conducteur à l'argent, le contact thermoconducteur sans potentiel (11) du composant de puissance (10) étant soudé à un plot de connexion (4p) de la couche de piste conductrice supérieure (4) et de la colle conductrice (8) dépassant de la tranchée (7) étant appliqué sur une partie du plot de connexion, de sorte que le plot de connexion est en liaison thermique avec la couche de base (2) par l'intermédiaire de la colle conductrice, la colle conductrice (8) dépassant de l'extrémité de la tranchée (7), les dimensions d'un bouchon de colle conductrice formé par la colle conductrice (8) étant comprises entre 0,1 mm et 0,5 mm, le composant de puissance (10) étant relié mécaniquement au support de circuit (1) exclusivement par brasage.

7. Support de circuit (1) selon la revendication 6, **caractérisé en ce que** la couche de base métallique (2) est un substrat en aluminium.

8. Support de circuit (1) selon la revendication 6 ou 7, **caractérisé en ce que** la couche de base métallique (2) est une couche de cuivre.
